# EUROPEAN PATENT APPLICATION

(11) **EP 0 730 343 A1**
(43) Date of publication of application: **04.09.1996**
(21) Application number: 96301211.7
(22) Date of filing: 22.02.1996
(51) Int. Cl.: H03F 3/45

(54) **Improvements in transconductor circuits**

(30) Priority: 03.03.1995 GB 9504309
(71) Applicant: PLESSEY SEMICONDUCTORS LIMITED, Swindon, Wiltshire SN2 2QW (GB)
(72) Inventor: Lawton, Rodney James, Swindon, Wiltshire (GB)
(74) Representative: Burrington, Alan

(57) **Abstract**

A transconductor circuit is characterised in that there are means to create a negative resistance, a diode load and phasing means which in combination are adapted in operation to give total cancellation and thus a substantially infinite output impedance.

## Description

The present invention relates to imptovements in transconductor circuits.

Such circuits are used in a variety of applications including gyrators, amplifiers, active filters, oscillators, comparators, analogue-to-digital converters, radios, audio filters and data channels such as disc read/write filters.

The purpose of a transconductor circuit is to convert an input voltage into a current. In order to most effectively achieve this such a circuit should have an infinite output impedance, i.e. one equivalent to an open circuit.

### Figure 1

This shows a known transconductor circuit which has input terminals 1 and 2 and output terminals 3 and 4, a long tailed transistor pair 5 and 6, a pair of substantially equal value resistors 7 and 8, a balancing resistor 9, a second pair of transistors 11 and 12, variable tuning current input 13 and a pair of current terminals 14 and 15.

With this arrangement the functions of the transistors 11 and 12 is to normalise the loading effects of resistors 7 and 8. However, the common mode output voltage at 3, 4 is dependant upon the tuning current at 13 and this limits the tuning range. The range could be increased by making the resistors 7 and 8 variable but this would introduce other problems.

### Figure 2

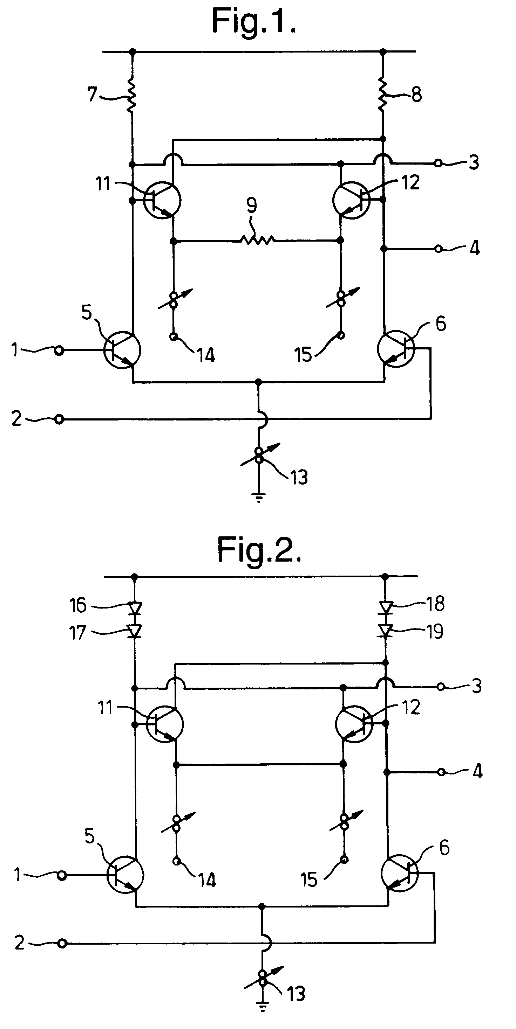

This illustrates a possible alternative circuit to overcome the disadvantages of the circuit of Figure 1, the same reference numerals being used to denote equipment circuit elements.

Essentially in the circuit of Figure 2 the fixed resistors 7 and 8 have been replaced by two pairs of diodes 16, 17 and 18, 19 respectively, the balancing resistor 9 no longer being required.

Although the circuit of Figure 2 will overcome the disadvantages described earlier of the circuit of Figure 1, because the diodes 16, 17, and 18, 19 have negligible resistance, it would then be necessary to not only vary the current at 13 but also at 14 and 15 as illustrated in Figure 2 in order to tune the circuit in order to maintain the neutralising effect of transistors 11 and 12.

An example of a prior art transconductor circuit is disclosed in Paper WP4.2 "A 27 MHz Programmable Bipolar 0.05° Equiripple Linear-Phase Lowpass Filter" by De Veirman & Yamasaki" on pages 64-65 of the 1992 IEEE International Solid-State Circuits Conference.

The present invention is concerned with overcoming these problems and providing a transconductor circuit which has substantially infinite output impedance and a wide tuning range.

The present invention is concerned with tuning continuous active filters, for example a gyrator. The particular application of the invention is in a linear sine wave oscillator for use in very small radio receivers, e.g. in a key fob. The critical element in the design of continuous - time filters is the transconductance element.

According to the present invention a transconductor circuit is characterised in that there are means to create a negative resistance, a diode load, and with phasing means which in combination are adapted in operation to give total cancellation and thus a substantially infinite output impedance. In both circuits positive feedback is used to cancel the finite impedances generated by the transconductor loads in order to generate the ideal infinite output impedance.

How the invention may be carried out will now be described by way of example only and with reference to the accompanying drawings in which:
Figure 1 is a circuit diagram of a first prior art transconductor;
Figure 2 is a circuit diagram of a second prior art transconductor;
Figure 3 is a circuit diagram of one embodiment of the present invention; and
Figure 4 is a circuit diagram of a second embodiment of the present invention.

### Figures 1 and 2

The prior art circuit shown in Figure 1 has already been described.

### Figures 3 and 4

These show two circuits incorporating the present invention, the same reference numerals being used to denote the equivalent circuit elements to those shown in Figures 1 and 2.

In both these circuits there is a differential transconductor 22 (below the dotted line) which is not part of the present invention, and an active load circuit (shown above the dotted line) which incorporates the present invention.

Both these embodiments have as their objective to make the transconductor network look like a differential pair without a load. Previous proposals can achieve this but suffer from limited common mode performance and narrow control range of 'gm'.

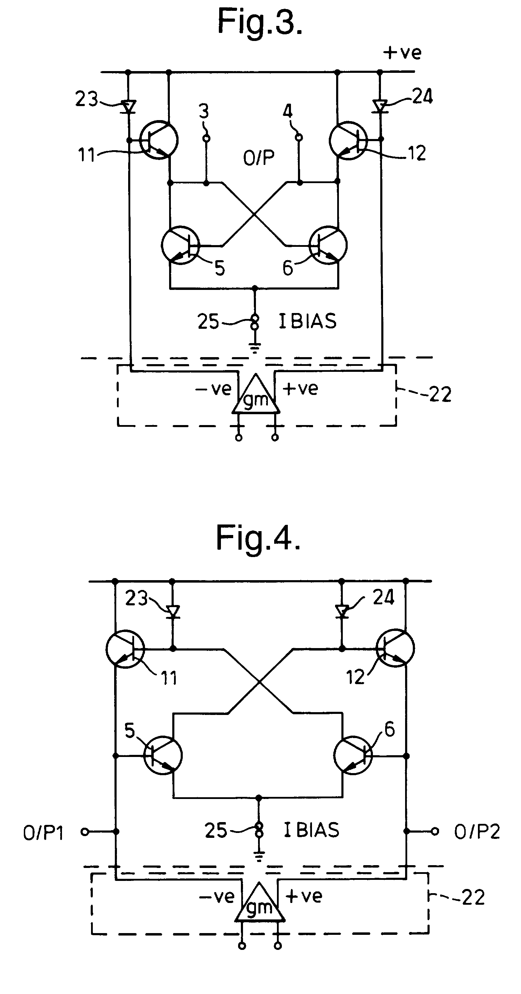

In the circuits of Figures 3 and 4 the resistors 7 and 8 of Figure 1 have been replaced by two diodes 23 and 24.

A bias current "I BIAS" is applied at 25.

The circuits of Figures 3 and 4 differ in the static bias voltage applied to the neutralising transistors 5, 6 and 11, 12.

In both the circuits of Figures 3 and 4 it is only necessary to change the "Gm current" in order to tune the circuit whereas in the circuit of Figure 2 it is necessary to change two currents.

With the circuits of the present invention the tuning current does not go through the diodes. each of the circuits of Figures 3 and 4 in effect incorporates a negative resistance, Gm, a diode load, 23, 24 and phasing to give total cancellation thus producing an infinite output impedance.

The circuits of the present invention thus overcome the problem of the prior art, in which the common mode output voltage is dependant upon the tuning current, and thus enable the tuning range of the circuit to be increased.

Although this could result in a potential non-linear load, in practice because the circuit would be used in a cascade system where the downstream stages provide the overall limiting factor of the arrangement as a whole, the latter never operates in the zone where this potential disadvantage would manifest itself.

The circuits of the present invention are designed to be realised in integrated form.

## Claims

1. A transconductor circuit is characterised in that there are means to create a negative resistance, a diode load and phasing means which in combination are adapted in operation to give total cancellation and thus a substantially infinite output impedance.

2. A transconductor circuit substantially as hereinbefore described with reference to and as shown in either Figure 3 or Figure 4 of the accompanying drawings.
